# EUROPÄISCHE PATENTSCHRIFT

(11) **EP 3 879 651 B1**
(45) Veröffentlichungstag und Bekanntmachung des Hinweises auf die Patenterteilung: **03.04.2024**
(21) Anmeldenummer: 21156241.8
(22) Anmeldetag: 10.02.2021
(51) Int. Cl.: H02G 11/02

(54) **KABELTROMMEL ZUR ENERGIEVERSORGUNG EINES ELEKTRISCH BETRIEBENEN NUTZFAHRZEUGS**
CABLE REEL FOR ENERGY SUPPLY OF AN ELECTRIC OPERATED COMMERCIAL VEHICLE
ENROULEUR DE CÂBLE DESTINÉ À L'ALIMENTATION EN ÉNERGIE D'UN VÉHICULE UTILITAIRE À COMMANDE ÉLECTRIQUE

(30) Priorität: 13.03.2020 DE 102020203283
(43) Veröffentlichungstag der Anmeldung: 15.09.2021
(73) Patentinhaber: Deere & Company, Moline, IL 61265 (US)
(72) Erfinder: KLEIN, ANDRE, 68163 Mannheim (DE); TARASINSKI, NICOLAI, 68163 Mannheim (DE); PFAFFMANN, SIMON, 68163 Mannheim (DE); KOESTERMEYER, THORSTEN, 68163 Mannheim (DE); KISSEL, MAX, 68163 Mannheim (DE)
(74) Vertreter: Dehnhardt, Florian Christopher

(56) Entgegenhaltungen:
- DE-C- 850 130
- US-A- 2 330 086

## Beschreibung

Die Erfindung bezieht sich auf eine Kabeltrommel zur Energieversorgung eines elektrisch betriebenen Nutzfahrzeugs, mit einem axial verlaufenden Wickelkörper, der sich zum Auf- und Abspulen eines elektrischen Kabels in Drehung versetzen lässt, wobei der Wickelkörper von einer schraubenförmig gewundenen Rohrleitung mit einem Einlass zur Zufuhr eines Kühlluftstroms gebildet ist.

Aus der DE 850 130 C geht eine Kabeltrommel zur Verwendung in elektrisch angetriebenen, ortsveränderlichen Geräten, wie beispielsweise Baggern oder anderen Fahrzeugen, hervor. Auf die Kabeltrommel wird ein der Stromführung dienendes elektrisches Kabel in mehreren Lagen auf- und abgewickelt, je nachdem, ob sich das Gerät einem stationären Kabeleinspeispunkt nähert oder von diesem entfernt. Die Kabeltrommel selbst umfasst einen Trommelmantel, der aus einer in lichtem Abstand gewickelten hohlen Rohrschlange gebildet ist, die in einen hohlen Teil einer drehbar gelagerten Kabeltrommelachse mündet. Durch einen Ventilator wird Kühlluft durch den hohlen Teil der Kabeltrommelachse und anschließend durch die Rohrschlange gedrückt, wobei deren offenes Ende in das Innere der Kabeltrommel gerichtet ist. Die Luft durchläuft dann zunächst die Windungen der Rohrschlange und strömt dann in das Innere der Trommel ein. Dadurch ergibt sich eine gegenüber konventionellen Kabeltrommeln verbesserte Wärmeabfuhr der auf den Trommelmantel aufgewickelten, sich verlustleistungsbedingt mehr oder minder erwärmenden Kabellagen.

Es ist Aufgabe der vorliegenden Erfindung, eine Kabeltrommel der eingangs genannten Art hinsichtlich ihrer Kühleffizienz weiter zu verbessern.

Diese Aufgabe wird durch eine Kabeltrommel mit den Merkmalen des Patentanspruchs 1 gelöst.

Die Kabeltrommel zur Energieversorgung eines elektrisch betriebenen Nutzfahrzeugs umfasst einen axial verlaufenden Wickelkörper, der sich zum Auf- und Abspulen eines elektrischen Kabels in Drehung versetzen lässt, wobei der Wickelkörper von einer schraubenförmig gewundenen Rohrleitung mit einem Einlass zur Zufuhr eines Kühlluftstroms gebildet ist. Erfindungsgemäß weist die Rohrleitung zur Erhöhung der Kühleffizienz eine Vielzahl von entlang ihrer Wandung ausgebildete Luftauslassöffnungen auf. Diese erlauben eine forcierte Kühlluftbeaufschlagung eines auf den Wickelkörper aufgespulten Kabelabschnitts. Die Luftauslassöffnungen können hierbei im Bereich des Wickelkörpers über die gesamte Länge der gewundenen Rohrleitung gleichmäßig verteilt angeordnet sein, sodass eine homogene Kühlung eines darauf aufgespulten Kabelabschnitts gewährleistet ist. Das Risiko unerwünschter lokaler Hitzeherde innerhalb aufeinanderliegender Kabellagen wird so maßgeblich reduziert. Da sich die Luftauslassöffnungen ohne zusätzlichen Platzbedarf in der Wandung der Rohrleitung einbringen lassen, ist zudem eine besonders kompakte Bauweise sichergestellt.

Zur Luftbeaufschlagung ist die Rohrleitung üblicherweise an einer Pressluftquelle angeschlossen, die Bestandteil eines mit der Kabeltrommel ausgestatteten elektrisch angetriebenen Nutzfahrzeugs ist. Die Pressluft kann zusätzlich ein Expansionsventil durchlaufen, um deren Temperatur vor dem Eintritt in die Rohrleitung abzusenken. Die Kühlwirkung lässt sich auf diese Weise weiter erhöhen.

Bei dem elektrisch angetriebenen Nutzfahrzeug kann es sich um eine Land-, Forst- oder Baumaschine handeln, die auf einem abgegrenzten Areal einen zugehörigen Arbeitsvorgang ausführt. Lediglich beispielhaft sei hier das Pflügen eines Felds mittels eines landwirtschaftlichen Traktors, ein mittels eines Mähdreschers oder eines Holzvollernters ausgeführter Erntevorgang, Baggerarbeiten mittels eines Schaufelladers in einer Kiesgrube, und dergleichen erwähnt.

Weitere vorteilhafte Ausgestaltungen der erfindungsgemäßen Kabeltrommel gehen aus den Unteransprüchen hervor.

Erfindungsgemäß sind die Luftauslassöffnungen radial nach außen in Richtung eines auf den Wickelkörper aufgespulten Kabelabschnitts ausgerichtet, sodass dieser unmittelbar mit der aus den Luftauslassöffnungen austretenden Kühlluft beaufschlagt wird. Die Kühlluft tritt hierbei im Bereich von zwischen den Kabellagen gebildeten Lücken hindurch und führt die dort angestaute Verlustwärme in die Außenumgebung ab. Die Luftauslassöffnungen sind typischerweise rund und/oder schlitzförmig ausgebildet.

Um eine möglichst homogene Kühlung sicherzustellen, ist erfindungsgemäß vorgesehen, dass die Luftauslassöffnungen zur Erzielung eines diffusen Kühlluftstroms entlang der Wandung abwechselnd in unterschiedlichen Winkeln zwischen 0 und 45 Grad in Bezug auf eine von dem Wickelkörper aufgespannte Radialebene orientiert sind.

Die Rohrleitung kann aus Metall und/oder Kunststoff hergestellt sein. Denkbar ist unter anderem die Verwendung eines Kunststoffmantelrohrs zum Schutz des aufgespulten Kabels, wobei dieses einen tragenden Metallkern aufweist.

Um einen möglichst ungehinderten Luftdurchtritt zwischen den Kabellagen zu erreichen, ist es von Vorteil, wenn der Abstand der einzelnen Windungen der Rohrleitung größer ist als der Außendurchmesser des Kabels.

Der gleiche Effekt ergibt sich für den Fall, dass der Durchmesser der Rohrleitung größer ist als der Außendurchmesser des Kabels. Hier stellt sich ein dem Größenunterschied entsprechender Abstand zwischen den Windungen der jeweiligen Kabellage ein.

Die erfindungsgemäße Kabeltrommel zur Energieversorgung eines elektrisch betriebenen Nutzfahrzeugs wird im Folgenden anhand der beigefügten Zeichnungen näher erläutert. Hierbei sind übereinstimmende bzw. bezüglich ihrer Funktion vergleichbare Komponenten mit denselben Bezugszeichen gekennzeichnet. Es zeigen:
- Fig. 1: eine perspektivische Ansicht eines Ausführungsbeispiels der erfindungsgemäßen Kabeltrommel, und
- Fig. 2: eine Schnittdarstellung der in Fig. 1 wiedergegebenen Kabeltrommel.

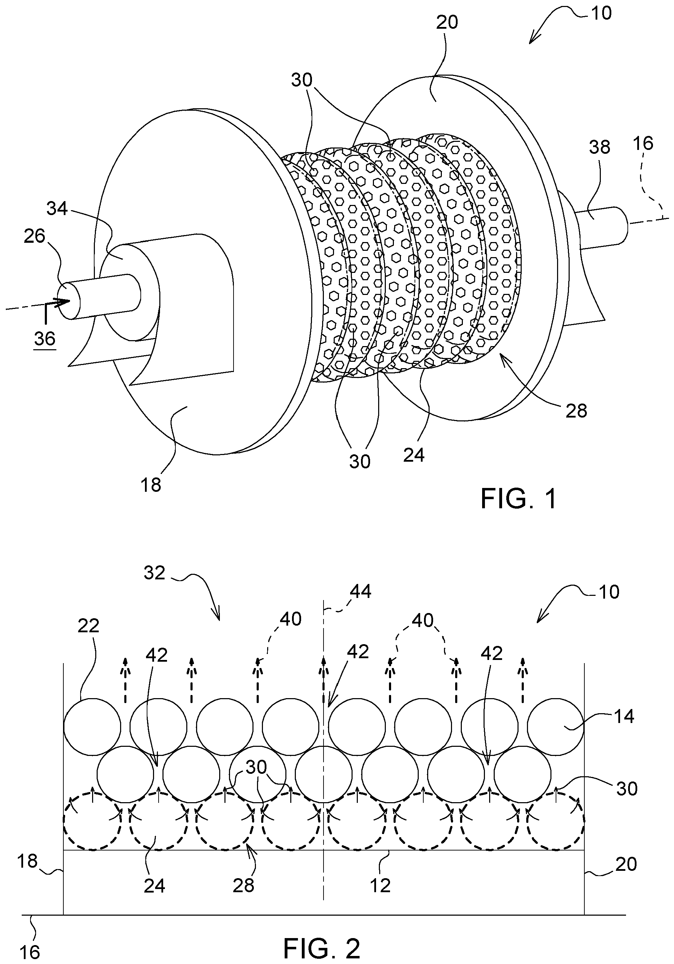

Fig. 1 zeigt eine perspektivische Ansicht eines Ausführungsbeispiels der erfindungsgemäßen Kabeltrommel zur Energieversorgung eines elektrisch betriebenen Nutzfahrzeugs. Die Kabeltrommel ist insbesondere Bestandteil einer Anordnung, wie sie in der DE 10 2018 212 150 A1 für den Fall eines als Feldhäcksler ausgebildeten Nutzfahrzeugs beschrieben ist.

Die Kabeltrommel 10 umfasst einen axial verlaufenden Wickelkörper 12, der sich zum Auf- und Abspulen eines in Fig. 2 gezeigten elektrischen Kabels 14 um eine Rotationsachse 16 in Drehung versetzen lässt. Hierzu steht der Wickelkörper 12 mit einem nicht gezeigten elektromotorischen Antrieb des Nutzfahrzeugs in Verbindung. Linke und rechte Abschlussflansche 18, 20 bilden eine axiale Begrenzung des Wickelkörpers 12.

Das Kabel 14 dient in erster Linie der Energieversorgung des Nutzfahrzeugs und umfasst eine Vielzahl von aus Kupfer bestehenden Einzeladern, die gegeneinander isoliert in einem schützenden Außenmantel 22 verlaufen. Zusätzlich kann das Kabel 14 der elektrischen und/oder optischen Datenübertragung dienen. In einem solchen Fall umfasst das Kabel 14 weitere Adern in Gestalt entsprechender Daten- und/oder Steuerleitungen. Eine optische Datenübertragung erfolgt dabei mittels kunststoffummantelter Lichtleiter.

Wie in Fig. 1 zu erkennen ist, ist der Wickelkörper 12 von einer schraubenförmig gewundenen Rohrleitung 24 mit einem Einlass 26 zur Zufuhr eines Kühlluftstroms gebildet. Die Rohrleitung 24 weist eine Vielzahl von entlang ihrer Wandung 28 ausgebildete Luftauslassöffnungen 30 auf. Diese erlauben eine forcierte Kühlluftbeaufschlagung eines auf den Wickelkörper 12 aufgespulten Kabelabschnitts 32. Die Luftauslassöffnungen 30 sind im Bereich des Wickelkörpers 12 über die gesamte Länge der gewundenen Rohrleitung 24 gleichmäßig verteilt angeordnet.

Beispielsgemäß sind die Luftauslassöffnungen 30 rund und/oder schlitzförmig ausgebildet.

Die Rohrleitung 24 ist über eine Drehdurchführung 34 an einer Pressluftquelle 36 angeschlossen, die Bestandteil des Nutzfahrzeugs ist. Gemäß einer optionalen Weiterbildung durchläuft die Pressluft zusätzlich ein Expansionsventil, um deren Temperatur vor dem Eintritt in die Rohrleitung 24 abzusenken.

Die Luftzufuhr seitens der Pressluftquelle 36 wird hierbei in Abhängigkeit des Bewicklungsgrads der Kabeltrommel 10 angepasst. So nimmt der Umfang der abzuführenden Abwärme naturgemäß mit geringer werdender Anzahl aufeinanderliegender Kabellagen ab. Die abgewickelte bzw. auf dem Wickelkörper 12 verbliebende Kabellänge kann beispielsweise mittels eines mit der Rotationsachse 16 verbundenen Drehgebers 38 bestimmt werden. Hierzu wird die mittels des Drehgebers 38 erfasste Anzahl an Umdrehungen sowie die Drehrichtung des Wickelkörpers 12 ausgewertet. Zusätzlich erfolgt die Berücksichtigung der über das Kabel 14 übertragenen elektrischen Leistung auf Grundlage einer sensorischen Messung der Stromstärke. Hierbei wird die Luftzufuhr mit geringer werdender Anzahl an Kabellagen bzw. abnehmender Stromstärke reduziert.

Entsprechend der Schnittdarstellung von Fig. 2 sind die Luftauslassöffnungen 30 radial nach außen in Richtung des auf den Wickelkörper 12 aufgespulten Kabelabschnitts 32 ausgerichtet, sodass dieser unmittelbar mit der aus den Luftauslassöffnungen 30 austretenden Kühlluft 40 beaufschlagt wird. Die Kühlluft 40 tritt hierbei im Bereich von zwischen den Kabellagen gebildeten Lücken 42 hindurch und führt die dort angestaute Verlustwärme in die Außenumgebung ab. Um eine möglichst homogene Kühlung sicherzustellen, sind die Luftauslassöffnungen 30 zur Erzielung eines diffusen Kühlluftstroms entlang der Wandung 28 abwechselnd in unterschiedlichen Winkeln zwischen 0 und 45 Grad in Bezug auf eine von dem Wickelkörper 12 aufgespannte Radialebene 44 orientiert.

Die Rohrleitung 24 ist aus Metall und/oder Kunststoff hergestellt. Denkbar ist unter anderem die Verwendung eines Kunststoffmantelrohrs zum Schutz des aufgespulten Kabels 14, wobei dieses einen tragenden Metallkern aufweist.

Um einen möglichst ungehinderten Luftdurchtritt zwischen den Kabellagen zu erreichen, ist in Fig. 2 der Mittenabstand der einzelnen Windungen der Rohrleitung 24 größer als der Außendurchmesser des Kabels 14.

Der gleiche Effekt ergibt sich für den in Fig. 2 nicht gezeigten Fall, dass der Durchmesser der Rohrleitung 24 größer ist als der Außendurchmesser des Kabels 14. Hier stellt sich ein dem Größenunterschied entsprechender Abstand zwischen den Windungen der jeweiligen Kabellage ein.

## Patentansprüche

1. Kabeltrommel zur Energieversorgung eines elektrisch betriebenen Nutzfahrzeugs, mit einem axial verlaufenden Wickelkörper (12), der sich zum Auf- und Abspulen eines Kabels (14) in Drehung versetzen lässt, wobei der Wickelkörper (12) von einer schraubenförmig gewundenen Rohrleitung (24) mit einem Einlass (26) zur Zufuhr eines Kühlluftstroms gebildet ist, **dadurch gekennzeichnet, dass** die Rohrleitung (24) eine Vielzahl von entlang ihrer Wandung (28) ausgebildete Luftauslassöffnungen (30) aufweist, die radial nach außen in Richtung eines auf den Wickelkörper (12) aufgespulten Kabelabschnitts (32) ausgerichtet sind, wobei die Luftauslassöffnungen (30) entlang der Wandung (28) abwechselnd in unterschiedlichen Winkeln zwischen 0 und 45 Grad in Bezug auf eine von dem Wickelkörper (12) aufgespannte Radialebene (44) orientiert sind.

2. Kabeltrommel nach wenigstens einem der vorhergehenden Ansprüche, **dadurch gekennzeichnet, dass** die Rohrleitung (24) aus Metall und/oder Kunststoff hergestellt ist.

3. Kabeltrommel nach wenigstens einem der vorhergehenden Ansprüche, **dadurch gekennzeichnet, dass** der Mittenabstand der einzelnen Windungen der Rohrleitung (24) größer ist als der Außendurchmesser des Kabels (14).

4. Kabeltrommel nach wenigstens einem der vorhergehenden Ansprüche, **dadurch gekennzeichnet, dass** der Durchmesser der Rohrleitung (24) größer ist als der Außendurchmesser des Kabels (14).

## Claims

1. Cable drum for supplying energy to an electrically powered utility vehicle, with an axially running winding body (12) which can be set in rotation in order to wind up and unwind a cable (14), wherein the winding body (12) is formed by a helically wound pipeline (24) with an inlet (26) for the supply of a cooling air stream, **characterized in that** the pipeline (24) has a multiplicity of air outlet openings (30) which are formed along its wall (28) and are oriented radially outwards in the direction of a cable portion (32) wound up onto the winding body (12), wherein the air outlet openings (30) are oriented along the wall (28) in an alternating manner at different angles between 0 and 45 degrees with respect to a radial plane (44) spanned by the winding body (12).

2. Cable drum according to at least one of the preceding claims, **characterized in that** the pipeline (24) is made of metal and/or plastic.

3. Cable drum according to at least one of the preceding claims, **characterized in that** the centre distance of the individual windings of the pipeline (24) is greater than the outer diameter of the cable (14).

4. Cable drum according to at least one of the preceding claims, **characterized in that** the diameter of the pipeline (24) is greater than the outer diameter of the cable (14).

## Revendications

1. Tambour de câble pour l'alimentation en énergie d'un véhicule utilitaire à commande électrique, avec un corps d'enroulement (12) s'étendant axialement, qui peut être mis en rotation pour envider et dévider un câble (14), le corps d'enroulement (12) étant formé par une conduite tubulaire (24) enroulée en hélice avec une entrée (26) pour l'amenée d'un courant d'air de refroidissement, **caractérisé en ce que** la conduite tubulaire (24) présente une pluralité d'ouvertures de sortie d'air (30) réalisées le long de sa paroi (28), qui sont dirigées radialement vers l'extérieur en direction d'une section de câble (32) envidée sur le corps d'enroulement (12), les ouvertures de sortie d'air (30) étant orientées le long de la paroi (28) alternativement selon des angles différents compris entre 0 et 45 degrés par rapport à un plan radial (44) défini par le corps d'enroulement (12).

2. Tambour de câble selon au moins l'une quelconque des revendications précédentes, **caractérisé en ce que** la conduite tubulaire (24) est fabriquée en métal et/ou en plastique.

3. Tambour de câble selon au moins l'une quelconque des revendications précédentes, **caractérisé en ce que** l'entraxe des spires individuelles de la conduite tubulaire (24) est supérieur au diamètre extérieur du câble (14).

4. Tambour de câble selon au moins l'une quelconque des revendications précédentes, **caractérisé en ce que** le diamètre de la conduite tubulaire (24) est supérieur au diamètre extérieur du câble (14).
